# EUROPÄISCHE PATENTANMELDUNG

(11) **EP 3 512 313 A1**
(43) Veröffentlichungstag der Anmeldung: **17.07.2019**
(21) Anmeldenummer: 18151792.1
(22) Anmeldetag: 16.01.2018
(51) Int. Cl.: H05K 1/14, H05K 3/36, H05K 3/40, H05K 3/00

(54) **LEITERPLATTENANORDNUNG**

(71) Anmelder: ZKW Group GmbH, 3250 Wieselburg (AT)
(72) Erfinder: Edlinger, Erik, 1090 Wien (AT); Albrecht, Emmerich, 1150 Wien (AT)
(74) Vertreter: Patentanwaltskanzlei Matschnig & Forsthuber OG

(57) **Zusammenfassung**

Leiterplattenanordnung (1), umfassend eine erste und eine zweite Leiterplatte (10, 20) mit jeweils einer Montageoberfläche (11, 21) zur Montage von elektronischen Bauteilen (70-75, 80-85). Die erste und die zweite Leiterplatte (10, 20) sind zueinander in einem Winkel (2) in einem Bereich von 80° bis 100°, bevorzugt unter einem Winkel von 90°, angeordnet. Zumindest eine erste Kontaktfläche (30-35) ist auf der Montageoberfläche (11) der ersten Leiterplatte (10) angeordnet. Zumindest eine zweite Kontaktfläche (40-45) der zweiten Leiterplatte (20) ist auf der Stirnseite, welche quer zur Montageoberfläche (21) der zweiten Leiterplatte (20) verläuft, angeordnet. Zumindest ein elektrisch leitendes Verbindungsmittel (50-55) verläuft von der zumindest einen ersten Kontaktfläche (30-35) zur zumindest einen zweiten Kontaktfläche (40-45).

## Beschreibung

Die Erfindung betrifft eine Leiterplattenanordnung, umfassend eine erste und eine zweite Leiterplatte mit jeweils einer Montageoberfläche zur Montage von elektronischen Bauteilen.

Ferner betrifft die Erfindung ein Kraftfahrzeugscheinwerfer-Lichtmodul und einen Kraftfahrzeugscheinwerfer.

Außerdem betrifft die Erfindung ein Verfahren zur Herstellung einer Leiterplattenanordnung, sowie ein Verfahren zur Herstellung einer Leiterplatte mit zumindest einer stirnseitigen Kontaktfläche für eine Leiterplattenanordnung.

Bei modernen Fahrzeugscheinwerfern, insbesondere KFZ-Scheinwerfern, bzw. Lichtmodulen, insbesondere solchen, die eine variable Lichtverteilung erzeugen können, werden vermehrt sehr lichtstarke Lichtquellen, meist Halbleiterdioden in der Form von Hochstrom-LEDs oder Laserdioden eingesetzt. Die Stromaufnahme von Hochstrom-LEDs kann dabei mehrere Ampere betragen.

Es kann daher erforderlich sein, dass die Elektronikschaltung in einem Lichtmodul oder einem Scheinwerfer auf getrennten Leiterplatten ausgeführt werden, um thermische, mechanische oder optische Anforderungen zu erfüllen.

Bei Lichtmodulen nach dem Stand der Technik, welche zwei Leiterplatten umfassen und beispielsweise eine Ansteuerungselektronik für Lichtquellen des Lichtmoduls auf einer ersten Leiterplatte, sowie Halbleiter-Lichtquellen auf einer zweiten Leiterplatte beinhalten, werden häufig die beiden Leiterplatten mittels einfacher Steckverbinder und Kabel miteinander verbunden. Dies kann bei den zuvor genannten hohen Stromstärken zu hohen elektrischen Verlusten führen, eine hohe Abwärme erzeugen, sowie einen großen Bauraum und eine komplizierte, teure Montage erfordern. Außerdem können Vibrationen des Fahrzeugs eine unerwünscht frühe Ermüdung von Steckverbindern und Kabeln verursachen.

Es ist eine Aufgabe der Erfindung die Nachteile im Stand der Technik zu überwinden.

Die Aufgabe wird durch eine Leiterplattenanordnung der eingangs genannten Art gelöst, indem die erste und die zweite Leiterplatte zueinander in einem Winkel in einem Bereich von 80° bis 100°, bevorzugt unter einem Winkel von 90°, angeordnet sind, und zumindest eine erste Kontaktfläche auf einer Montageoberfläche der ersten Leiterplatte angeordnet ist, und zumindest eine zweite Kontaktfläche der zweiten Leiterplatte auf einer Stirnseite, welche quer zu einer Montageoberfläche der zweiten Leiterplatte verläuft, angeordnet ist, und zumindest ein elektrisch leitendes Verbindungsmittel von der zumindest einen ersten Kontaktfläche zur zumindest einen zweiten Kontaktfläche verläuft.

Durch die Erfindung wird erreicht, dass die erste und die zweite Leiterplatte der Leiterplattenanordnung in der für einen Einbau in einem Lichtmodul oder in einem Kraftfahrzeugscheinwerfer vorgesehenen Lage angeordnet sind. Außerdem können die Kontaktflächen auf der ersten und der zweiten Leiterplatte auf eine einfache Weise elektrisch leitend miteinander verbunden werden. Die vorgesehene Lage der Leiterplattenanordnung erlaubt beispielsweise eine einfache Justierung mit weiteren Bauteilen des Lichtmoduls oder des Kraftfahrzeugscheinwerfers.

Es ist günstig, wenn sich die Ebenen, in denen die Montageoberflächen der ersten und zweiten Leiterplatten gelegen sind, nicht innerhalb, sondern außerhalb der Montageoberfläche der ersten Leiterplatte schneiden. Dadurch kann die Anordnung besonders einfach und kostengünstig hergestellt werden.

Es ist besonders günstig, wenn die erste und die zweite Leiterplatte auf einem gemeinsamen Halter angeordnet sind, welcher bevorzugt ein Kühlkörper ist. Dadurch kann auf eine einfache Weise eine Justierung zwischen den beiden Leiterplatten mittels des Halters erfolgen, beispielsweise unter Zuhilfenahme von Justiermarken, Justierstiften bzw. Justieröffnungen.

Es ist besonders günstig, wenn das elektrisch leitende zumindest eine Verbindungsmittel ein Bonddraht ist, vorzugsweise mit einem Durchmesser in einem Bereich von 100 µm bis 1000 µm, besonders bevorzugt in einem Bereich von 400 µm bis 600 µm, und der Bonddraht vorzugsweise Aluminium beinhaltet, und das zumindest eine Verbindungsmittel von der ersten Kontaktfläche zur zweiten Kontaktfläche durch ein Bond-Verfahren, vorzugsweise ein Wedge-Bond-Verfahren, hergestellt ist. Durch diese vorteilhafte Wahl des Verbindungsmittels und des entsprechenden Verfahrens zur Herstellung der Verbindung wird eine besonders einfache Umsetzung der Verbindung zwischen den Kontaktflächen auf der ersten und der zweiten Leiterplatte erreicht.

Beispielhaft wird das Thermosonic-Ball-Wedge-Bonden (TS-Bonden) und das Ultraschall-Wedge-Wedge-Bonden (US-Bonden) genannt.

Eine Aufgabe der Erfindung wird auch durch ein eingangs genanntes Kraftfahrzeugscheinwerfer-Lichtmodul gelöst, welches eine erfindungsgemäße Leiterplattenanordnung umfasst, wobei auf zumindest einer Leiterplatte, insbesondere auf der zweiten Leiterplatte, zumindest eine Halbleiter-Lichtquelle, vorzugsweise eine LED, eine Hochstrom-LED oder eine Laser-Diode, angeordnet ist. Diese Anordnung der Halbleiter-Lichtquellen erlaubt eine besonders einfache und kostengünstige Ausführung der erfindungsgemäßen Leiterplattenanordnung als Lichtmodul in einem Kraftfahrzeugscheinwerfer.

Eine Aufgabe der Erfindung wird außerdem durch einen eingangs genannten Kraftfahrzeugscheinwerfer gelöst, welcher ein erfindungsgemäßes Kraftfahrzeugscheinwerfer-Lichtmodul umfasst. Die Anordnung des Lichtmoduls in einem Kraftfahrzeugscheinwerfer erlaubt eine besonders einfache und kostengünstige Ausführung eines Kraftfahrzeugscheinwerfers.

Eine Aufgabe der Erfindung wird außerdem durch ein eingangs genanntes Verfahren zur Herstellung einer Leiterplatte mit zumindest einer stirnseitigen Kontaktfläche für eine erfindungsgemäße Leiterplattenanordnung gelöst, wobei folgende Verfahrensschritte ausgeführt werden:
- Erzeugen zumindest eines durchgehenden Lochs, welches quer zu der Montageoberfläche der Leiterplatte verläuft, wobei das zumindest eine Loch eine innenliegende elektrisch leitende Oberfläche aufweist und mit zumindest einer Anschlussfläche auf der Leiterplatte elektrisch leitend verbunden ist;
   Die innenliegende elektrisch leitende Oberfläche beinhaltet vorzugsweise "electroless nickel immersion gold" (ENIG) beschichtetes Kupfer.
   Die Anschlussfläche auf der Leiterplatte ist zum Kontaktieren mit einem elektronischen Bauteil vorgesehen.
- Durchtrennen der Leiterplatte entlang einer gedachten Trennlinie, wobei die Trennlinie durch das zumindest eine Loch verläuft.
   Die zumindest eine Kontaktfläche ist auf der Stirnseite, welche quer zur Montageoberfläche der Leiterplatte verläuft, bereitgestellt.
   Das Durchtrennen erfolgt bevorzugt mit einer Säge.

Das Verfahren zur Herstellung einer Leiterplatte mit zumindest einer stirnseitigen Kontaktfläche bezieht sich auf die Verwendung der Leiterplatte mit zumindest einer stirnseitigen Kontaktfläche beim Anordnen in einer erfindungsgemäßen Leiterplattenanordnung.

Dadurch wird erreicht, dass eine Leiterplatte mit zumindest einer stirnseitigen Kontaktfläche für die erfindungsgemäße Leiterplattenanordnung auf einfache und kostengünstige Weise hergestellt werden kann.

Es ist dabei besonders günstig, wenn das zumindest eine Loch einen kleinsten Durchmesser von größer oder gleich 0,5 mm, bevorzugt größer oder gleich 1 mm, besonders bevorzugt größer oder gleich 1,5 mm, aufweist. Dadurch kann erreicht werden, dass die stirnseitige Kontaktfläche, welche durch das Durchtrennen des Lochs hergestellt wird, genug Stabilität aufweist.

Das Loch kann eine runde oder auch eckige Form aufweisen. Es ist auch eine Formgebung eines Langlochs möglich, welches zur Bildung der stirnseitigen Kontaktfläche längs durchtrennt wird. Dies ist insbesondere dann sinnvoll, wenn beispielsweise mehrere parallel geführte Verbindungsmittel, beispielsweise in Form von Bonddrähten von einer gemeinsamen Kontaktfläche der ersten Leiterplatte zu einer gemeinsamen stirnseitigen Kontaktfläche der zweiten Leiterplatte geführt werden sollen, um beispielsweise höhere Ströme führen zu können.

Bei Verwendung eines Langlochs kann das zumindest eine Loch einen größten Durchmesser von größer oder gleich 0,5 mm, bevorzugt größer oder gleich 1 mm, besonders bevorzugt größer oder gleich 1,5 mm, 2,0 mm oder 2,5 mm, aufweisen.

Somit kann sich für ein Langloch eine Kombination aus dem oben genannten kleinsten und größten Durchmesser ergeben.

Bevorzugt liegt der größte Durchmesser des zumindest einen Lochs in der Ebene des Schnitts für die Durchtrennung entlang der Trennlinie der Stirnseite der zweiten Leiterplatte.

Eine langerstreckte, stirnseitige Kontaktfläche der zweiten Leiterplatte kann beispielsweise auch dann sinnvoll sein, wenn als Verbindungsmittel ein Bondband, also ein Bonddraht mit einem asymmetrischen Querschnitt, insbesondere ein Aluminium-Bondband, verwendet wird, um einen geringen elektrischen Widerstand der Verbindung zu erreichen und höhere Ströme führen zu können.

Dadurch wird es möglich, beim Durchtrennen einen Sägeprozess mit einer einfachen, für die Leiterplattenbearbeitung vorgesehenen Säge durchzuführen, ohne eine unerwünschte mechanische Beeinträchtigung der verbleibenden stirnseitigen Kontaktfläche zu erhalten.

Eine Aufgabe der Erfindung wird ferner durch ein eingangs genanntes Verfahren zur Herstellung einer erfindungsgemäßen Leiterplattenanordnung gelöst, wobei die Leiterplattenanordnung eine erste und eine zweite Leiterplatte mit jeweils einer Montageoberfläche zur Montage von elektronischen Bauteilen umfasst, wobei zumindest eine erste Kontaktfläche auf der Montageoberfläche der ersten Leiterplatte angeordnet ist, und zumindest eine zweite Kontaktfläche auf der Stirnseite, welche quer zur Montageoberfläche der zweiten Leiterplatte verläuft, angeordnet ist, und folgende Verfahrensschritte ausgeführt werden:
- Optional: Erzeugen zumindest eines durchgehenden Lochs, welches quer zu der Montageoberfläche der Leiterplatte verläuft und mit zumindest einer Anschlussfläche auf der zweiten Leiterplatte elektrisch leitend verbunden ist;
   Das zumindest eine Loch eine innenliegende elektrisch leitende Oberfläche, vorzugsweise aus "electroless nickel immersion gold" (ENIG) beschichtetem Kupfer. Das zumindest eine Loch weist dabei einen kleinsten Durchmesser von größer oder gleich 0,5 mm, bevorzugt größer oder gleich 1 mm, besonders bevorzugt größer oder gleich 1,5 mm, auf.
   Die zweite Leiterplatte ist zum Kontaktieren mit einem elektronischen Bauteil vorgesehen.
- Optional: Durchtrennen der Leiterplatte entlang einer gedachten Trennlinie, wobei die Trennlinie durch das zumindest eine Loch verläuft;
   Das Durchtrennen der Leiterplatte erfolgt entlang einer gedachten Trennlinie bevorzugt mit einer Säge.
   Durch das Durchtrennen ist zumindest eine Kontaktfläche auf der Stirnseite, welche quer zur Montageoberfläche der Leiterplatte verläuft, bereitgestellt.
- Anordnen der ersten und der zweiten Leiterplatte auf einem gemeinsamen Halter und in einem Winkel zueinander, wobei die zumindest eine zweite Kontaktfläche benachbart zur zumindest einen ersten Kontaktfläche gelegen ist;
   Der gemeinsame Halter ist bevorzugt ein Kühlkörper.
   Der Winkel liegt in einem Bereich von 80° bis 100°, bevorzugt bei 90°.
- Verbinden der zumindest einen ersten Kontaktfläche, welche auf der Montagefläche der ersten Leiterplatte gelegen ist, mit der zumindest einen zweiten Kontaktfläche, welche auf der Stirnseite der zweiten Leiterplatte gelegen ist, mittels zumindest einem elektrisch leitenden Verbindungsmittel.

Die optionalen Schritte Erzeugen und Durchtrennen können alternativ durch folgenden Schritt ersetzt werden:
- Bereitstellen einer Leiterplatte mit zumindest einer stirnseitigen Kontaktfläche.

In diesem Zusammenhang bedeutet "benachbart gelegen", dass die zumindest eine erste Kontaktfläche in einem Randbereich der ersten Leiterplatte gelegen ist, und die zumindest eine zweite Kontaktfläche an der Stirnseite der zweiten Leiterplatte gelegen ist, und der Randbereich der ersten Leiterplatte der Stirnseite der zweiten Leiterplatte zugewandt angeordnet ist. In einer Ansicht der Leiterplattenanordnung von oben, das heißt eine Aufsicht auf die Montageoberfläche der ersten Leiterplatte, liegen die erste und die zweite Leiterplatte nebeneinander oder aneinander angrenzend.

Durch das erfindungsgemäße Verfahren kann erreicht werden, dass die erste und die zweite Leiterplatte der erfindungsgemäßen Anordnung auf besonders einfache und kostengünstige Weise miteinander elektrisch leitend verbunden werden. Die hergestellte Verbindung ist besonders robust und unempfindlich gegen mechanische Vibrationen und weist überdies hinaus einen sehr geringen Leitungswiderstand auf, wodurch die elektrischen Verluste, insbesondere bei hohen Stromstärken, reduziert sind.

Es ist besonders günstig, wenn das Verbinden mittels dem zumindest einen elektrisch leitenden Verbindungsmittel durch eine Verbindungsvorrichtung erfolgt, welche dazu vorgesehen ist, das Verbindungsmittel auf der zumindest einen ersten Kontaktfläche und der zumindest einen zweiten Kontaktfläche anzubringen, wobei das Anbringen mittels einer dreiachsig parametrisierbaren Bewegung der Verbindungsvorrichtung ausführbar ist.

Dadurch kann erreicht werden, dass keine hohen Anforderungen an die Verbindungsvorrichtung gestellt werden. Somit ist beispielsweise eine einfache Wedge-Bond-Vorrichtung zur Herstellung der Bond-Verbindung geeignet.

Für einen Einsatz der Leiterplattenanordnung in einem Lichtmodul bzw. einem Scheinwerfer sind wichtige Teile beschrieben, wobei klar ist, dass ein Lichtmodul bzw. ein Scheinwerfer noch viele andere Teile enthält, die einen sinnvollen Einsatz in einem Kraftfahrzeug, wie insbesondere einem PKW oder Motorrad, ermöglichen, auf welche jedoch an dieser Stelle nicht näher eingegangen wird.

Die Erfindung und weitere Vorteile werden im Folgenden anhand von nicht einschränkenden Ausführungsbeispielen näher beschrieben, die in den beiliegenden Zeichnungen veranschaulicht sind. Die Zeichnungen zeigen in
- Fig. 1: eine perspektivische Ansicht einer schematischen Darstellung einer Ausführungsform erfindungsgemäßen Leiterplattenanordnung,
- Fig. 2: einen vergrößerten Ausschnitt der Ansicht der Leiterplattenanordnung nach der Fig. 1,
- Fig. 3: eine Darstellung einer Ausführungsform eines erfindungsgemäßen Verfahrens zur Herstellung einer Leiterplatte,
- Fig. 4: eine Ansicht auf eine Leiterplatte für die Leiterplattenanordnung der Fig. 1 nach dem ersten Verfahrensschritt gemäß der Fig. 3,
- Fig. 5: eine Ansicht auf die Leiterplatte für die Leiterplattenanordnung der Fig. 1 nach dem zweiten Verfahrensschritt gemäß der Fig. 3,
- Fig. 6a-6d: eine Ansicht auf die Leiterplattenanordnung der Fig. 1, welche nach dem erfindungsgemäßen Verfahren gemäß der Fig. 7 hergestellt wird,
- Fig. 7: eine Darstellung einer Ausführungsform eines erfindungsgemäßen Verfahrens zur Herstellung einer Leiterplattenanordnung,
- Fig. 8: eine schematische Darstellung eines Kraftfahrzeugscheinwerfers und eines Lichtmoduls nach der Erfindung.

Es werden nun Ausführungsbeispiele der Erfindung näher erläutert. Insbesondere sind für die Erfindung in einem Lichtmodul bzw. einem Scheinwerfer wichtige Teile dargestellt, wobei klar ist, dass ein Lichtmodul bzw. ein Scheinwerfer noch viele andere, nicht gezeigte Teile enthält, die einen sinnvollen Einsatz in einem Kraftfahrzeug, wie insbesondere einem PKW oder Motorrad, ermöglichen. Der Übersichtlichkeit halber sind daher beispielsweise Kühlvorrichtungen für Bauteile, Ansteuerungselektronik, weitere optische Elemente, mechanische Verstelleinrichtungen beziehungsweise Halterungen nicht gezeigt.

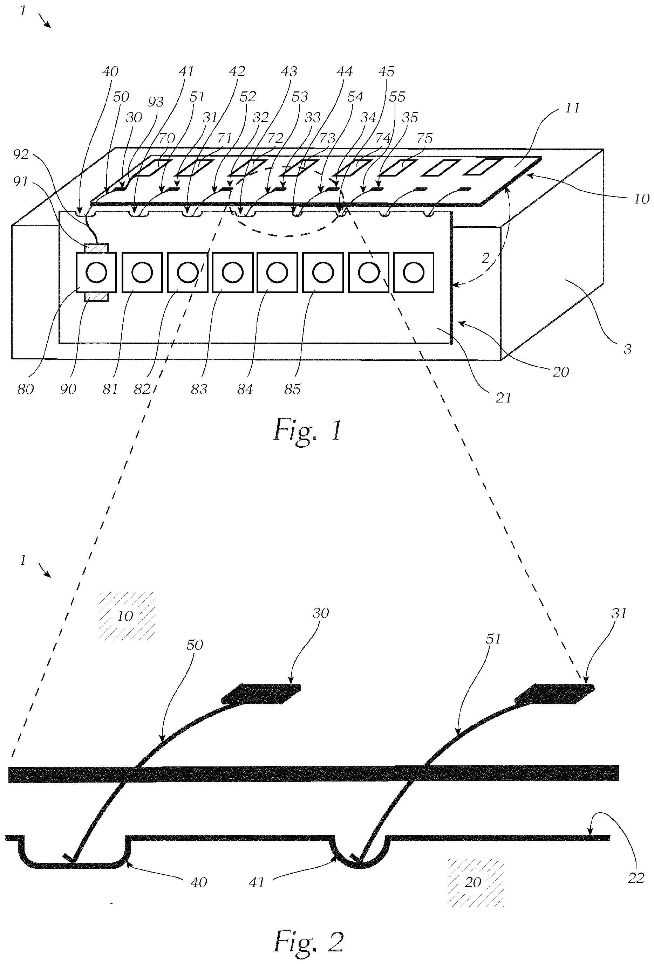

**Fig. 1** zeigt ein Ausführungsbeispiel einer Leiterplattenanordnung 1, umfassend eine erste und eine zweite Leiterplatte 10, 20 mit jeweils einer Montageoberfläche 11, 21 zur Montage von elektronischen Bauteilen 70-75, 80-85.

In diesem Ausführungsbeispiel sind die elektronischen Bauteile 70-75 Treiberschaltungen in Form von integrierten Schaltungen und die elektronischen Bauteile 80-85 LEDs.

Die erste und die zweite Leiterplatte 10, 20 sind zueinander in einem Winkel 2 von 90° angeordnet sind.

Erste Kontaktflächen 30-35 sind auf der Montageoberfläche 11 der ersten Leiterplatte 10 angeordnet. Zweite Kontaktflächen 40-45 der zweiten Leiterplatte 20 sind auf der Stirnseite 22, welche quer zur Montageoberfläche 21 der zweiten Leiterplatte 20 verläuft, angeordnet.

Jene Ebenen, in denen die Montageoberflächen 11, 21 der ersten und zweiten Leiterplatten 10, 20 gelegen sind, schneiden sich nicht innerhalb, sondern außerhalb der Montageoberfläche 11 der ersten Leiterplatte 10.

Elektrisch leitende Verbindungsmittel 50-55 verlaufen von den ersten Kontaktflächen 30-35 zu den zweiten Kontaktflächen 40-45.

Die erste und die zweite Leiterplatte 10, 20 sind auf einem gemeinsamen Halter 3 angeordnet, welcher bevorzugt ein Kühlkörper ist.

Die elektrisch leitenden Verbindungsmittel 50-55 sind jeweils Bonddrähte, welche vorzugsweise einen Durchmesser in einem Bereich von 100 µm bis 1000 µm, besonders bevorzugt in einem Bereich von 400 µm bis 600µm, aufweisen. In diesem Ausführungsbeispiel beträgt der Durchmesser 500 µm. Die Bonddrähte beinhalten vorzugsweise Aluminium, wobei auch andere Metalle geeignet sind. Die Verbindungsmittel 50-55 von den ersten Kontaktflächen 30-35 zu den zweiten Kontaktflächen 40-45 sind durch ein Bond-Verfahren, vorzugsweise ein Wedge-Bond-Verfahren, hergestellt.

**Fig. 2** zeigt eine vergrößerte Darstellung eines Ausschnitts nach der Fig. 1 mit den Verbindungsmitteln 50-55, welche von den ersten Kontaktflächen 30-35 zu den zweiten Kontaktflächen 40-45 verlaufen.

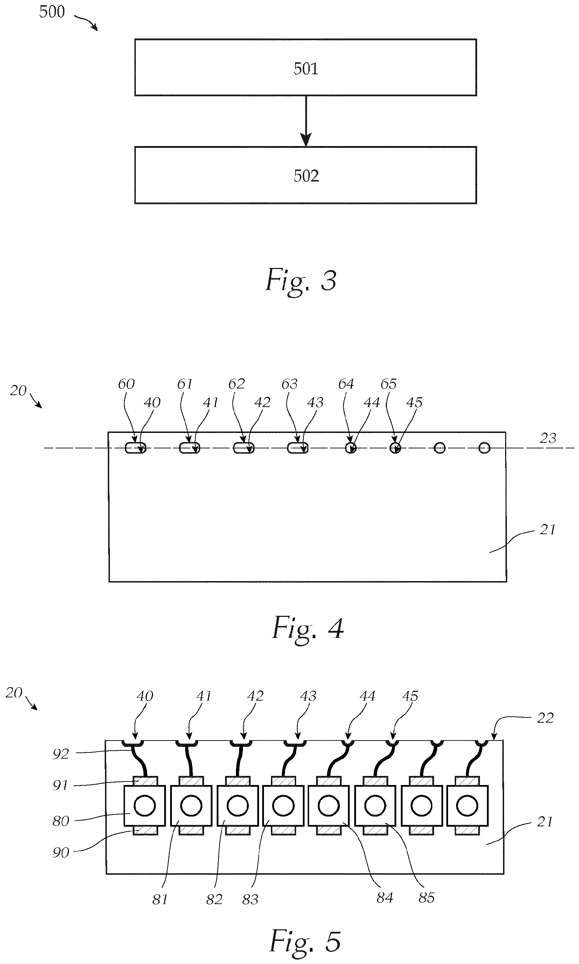

**Fig. 3** stellt ein Verfahren 500 zur Herstellung einer Leiterplatte 20 mit zumindest einer stirnseitigen Kontaktfläche 40-45 für eine erfindungsgemäße Leiterplattenanordnung 1 dar. Folgende Verfahrensschritte werden dabei ausgeführt:
- Erzeugen 501 zumindest eines durchgehenden Lochs 60-65, welches quer zu der Montageoberfläche 21 der Leiterplatte 20 verläuft. Das zumindest eine Loch 60-65 weist eine innenliegende elektrisch leitende Oberfläche, vorzugsweise aus "electroless nickel immersion gold" ENIG beschichtetem Kupfer, auf. Die innenliegende elektrisch leitende Oberfläche ist mit zumindest einer Anschlussfläche 90, 91 auf der Leiterplatte 20, welche zum Kontaktieren mit einem elektronischen Bauteil 80-85 vorgesehen ist, elektrisch leitend verbunden.
- Durchtrennen 502 der Leiterplatte 20 entlang einer gedachten Trennlinie 23, bevorzugt mit einer Säge. Die Trennlinie 23 verläuft durch das zumindest eine Loch 60-65. Durch das Abtrennen wird zumindest eine Kontaktfläche 40-45 auf der Stirnseite 22, welche quer zur Montageoberfläche 21 der Leiterplatte 20 verläuft, bereitgestellt.

**Fig. 4** zeigt ein Ausführungsbeispiel für die zweite Leiterplatte 20, welches nach dem Herstellungsverfahren gemäß der Fig. 3 nach dem Schritt des Erzeugens 501 hergestellt ist. Es sind mehrere Löcher 60-65 erkennbar, welche jeweils eine innenliegende elektrisch leitende Oberfläche, vorzugsweise aus "electroless nickel immersion gold" ENIG beschichtetem Kupfer, aufweisen und jeweils einen Teil der Kontaktflächen 40-45 bilden.

Es ist eine Trennlinie 23 erkennbar, an deren Verlauf im Anschluss an den Verfahrensschritt Erzeugen 501 ein nachfolgender Verfahrensschritt Durchtrennen 502, in welchem ein Schnitt durch die Leiterplatte 20 durchgeführt wird, folgt.

Das Ergebnis aus dem Verfahrensschritt Durchtrennen 502 ist in Fig. 5 mit einer Aufsicht auf die Montageoberfläche 21 der zweiten Leiterplatte 20 gezeigt. Es ist die Leiterplatte 20 mit Kontaktflächen 40-45, Anschlussflächen 90, 91 und Leiterbahnen 92 erkennbar, auf welche elektronische Bauteile 80-85 in Form von LEDs bestückt und verlötet sind. Die Kontaktflächen 40-45 sind jeweils auf der Stirnseite 22 ausgeführt und elektrisch leitend mittels Leiterbahnen 92 mit den Anschlussflächen 90, 91 verbunden.

Die bestückte Leiterplatte 20 wird im weiteren Verlauf der Herstellung der Leiterplattenanordnung 1 verwendet.

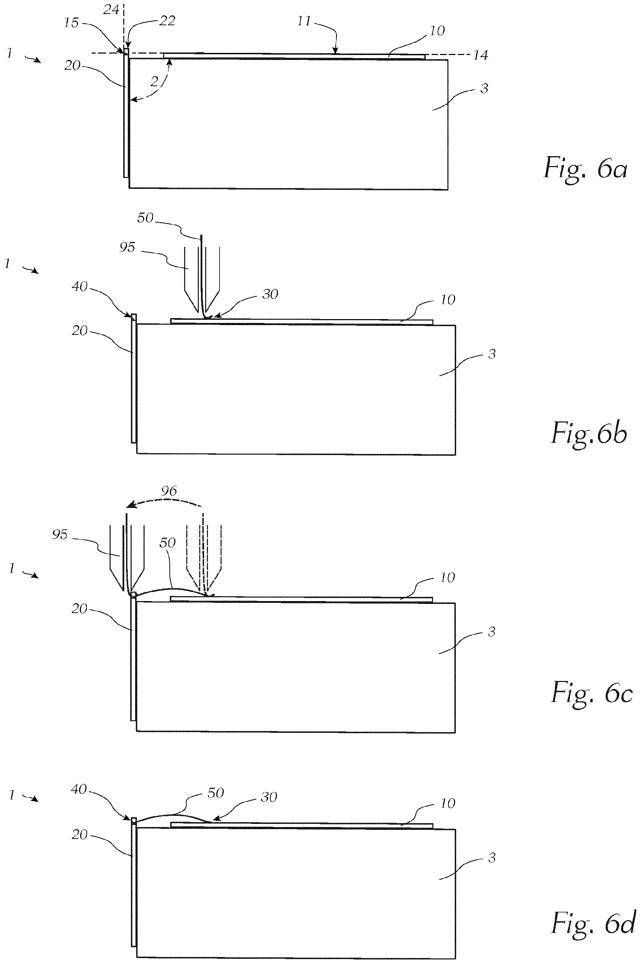

Die Fig. 6a bis 6d zeigen Verfahrensschritte mittels eines Wedge-Wedge-Bond-Verfahrens zur Herstellung eines Verbindungsmittels 50 von den ersten Kontaktflächen 30-35 der ersten Leiterplatte 10 zu den zweiten Kontaktflächen 40-45 der zweiten Leiterplatte 20. In diesem Ausführungsbeispiel ist das Verbindungsmittel 50 ein Aluminium-Bonddraht mit einem Durchmesser von 500 µm.

Im ersten Schritt gemäß der Fig. 6a werden die beiden Leiterplatten 10 und 20 auf einem Halter 3 angeordnet, wobei ein Winkel 2 zwischen den beiden Leiterplatten 10 und 20 vorliegt. Es ergibt sich, dass die Montageoberfläche 11 der ersten Leiterplatte 10 und die Stirnseite 22 der zweiten Leiterplatte 20 in dieselbe Richtung orientiert sind.

Es ist ferner erkennbar, dass sich eine Ebene 14, in welcher die Montageoberfläche 11 der ersten Leiterplatte 10 gelegen ist, und eine Ebene 24, in welcher die Montageoberfläche 21 der zweiten Leiterplatte 20 gelegen ist, in der Schnittlinie 15 schneiden. Die Schnittlinie 15 liegt außerhalb der Montageoberfläche 11 der ersten Leiterplatte 10 und verläuft normal zur Zeichnungsebene.

Vorzugsweise weisen die beiden Leiterplatten 10 und 20 Justiermarken auf, beispielsweise in Form von Justieröffnungen in den Leiterplatten 10, 20, und der Halter 3 beinhaltet dazu jeweils korrespondierende Justierstifte, um gleichzeitig mit der Anordnung eine Ausrichtung zu weiteren Bauteilen eines Lichtmoduls oder eines Scheinwerfers zu erreichen.

In einer Ansicht von oben auf die Leiterplattenanordnung 1, das heißt eine Aufsicht auf die Montageoberfläche 11 der ersten Leiterplatte 10 zeigt sich, dass die Montageoberfläche 11 der ersten Leiterplatte 10 und die Stirnseite 22 der zweiten Leiterplatte 20 nebeneinander angeordnet sind. Mit anderen Worten überlappen sich die erste Leiterplatte 10 und die zweite Leiterplatte 20 in einer Ansicht von oben nicht.

Es ist nicht unbedingt notwendig, dass die Montageoberfläche 11 der ersten Leiterplatte 10 und die Stirnseite 22 der zweiten Leiterplatte 20 in einer Ebene ausgerichtet sind. Jedoch kann bei einer Ausrichtung der Montageoberfläche 11 der ersten Leiterplatte 10 und der Stirnseite 22 der zweiten Leiterplatte 20 in einer Ebene der Bondprozess einfacher ausgeführt werden.

Gemäß der **Fig. 6b** wird mittels einer Bond-Vorrichtung 95 das Verbindungsmittel 50 in Form eines Bonddrahts an der ersten Kontaktflächen 30 beispielsweise durch ein Wedge-Bond-Verfahren angebracht, indem der Kopf der Bond-Vorrichtung 95 abgesenkt wird.

Die Bond-Vorrichtung 95 verfügt beispielsweise über eine Kapillar-Spitze, in welcher der Bond-Draht eingefädelt ist. Beim Absenken des Kopfs wird der Bonddraht auf die erste Kontaktfläche 30 gepresst und bei Zufuhr von Wärme und Anwendung einer Mikro-Bewegung wird der Bonddraht auf die erste Kontaktfläche 30 geschweißt.

Anschließend wird der Kopf der Bond-Vorrichtung 95 angehoben und zur Position der zweiten Kontaktfläche 40 der zweiten Leiterplatte 20 verfahren, wie in Fig. 6c dargestellt.

Das Verbinden mittels dem Bonddraht 50 erfolgt durch die Bond-Vorrichtung 95, wobei das Anbringen mittels einer dreiachsig parametrisierbaren Bewegung 96 der Bond-Vorrichtung 95 ausführbar ist. Dies bedeutet, dass die Bewegung 96 der Bond-Vorrichtung 95 erfolgen kann, ohne dass der Kopf der Bond-Vorrichtung 95 geneigt werden muss. Es ist allerdings auch klar, dass es trotzdem vorteilhaft sein kann, den Kopf beim Bond-Vorgang zu neigen, beispielsweise um einen verbesserten Verlauf des Bonddrahts zu ermöglichen oder den Bond-Vorgang selbst zu erleichtern.

An der Position der zweiten Kontaktfläche 40 der zweiten Leiterplatte 20 wird der Kopf erneut abgesenkt und in gleicher Weise, wie vorher erläutert, der Bonddraht auf die zweite Kontaktfläche 40 geschweißt. Dabei wird der Bonddraht nach der Schweißstelle abgetrennt, und die Verbindung mittels des Bonddrahts 50 von der ersten Kontaktfläche 30 der ersten Leiterplatte 10 zu der zweiten Kontaktfläche 40 der zweiten Leiterplatte 20 ist hergestellt, wie in **Fig. 6d** gezeigt. Für die weiteren Verbindungen zwischen ersten Kontaktflächen 31-35 zu den zweiten Kontaktflächen 41-45 wird dementsprechend vorgegangen.

Es ist klar, dass beim Bondprozess zusätzlich Wärme zugeführt werden kann, beispielweise durch seitens der Bond-Vorrichtung 95 vorgesehene Heizelemente. Dem Fachmann ist auch klar, dass beim Bondprozess Ultraschall-Bewegungen des Kopfs der Bond-Vorrichtung 95 den Schweiß-Vorgang beim Bonden unterstützen können, wie beispielsweise beim Ultraschall-Wedge-Wedge-Bonden (US-Bonden).

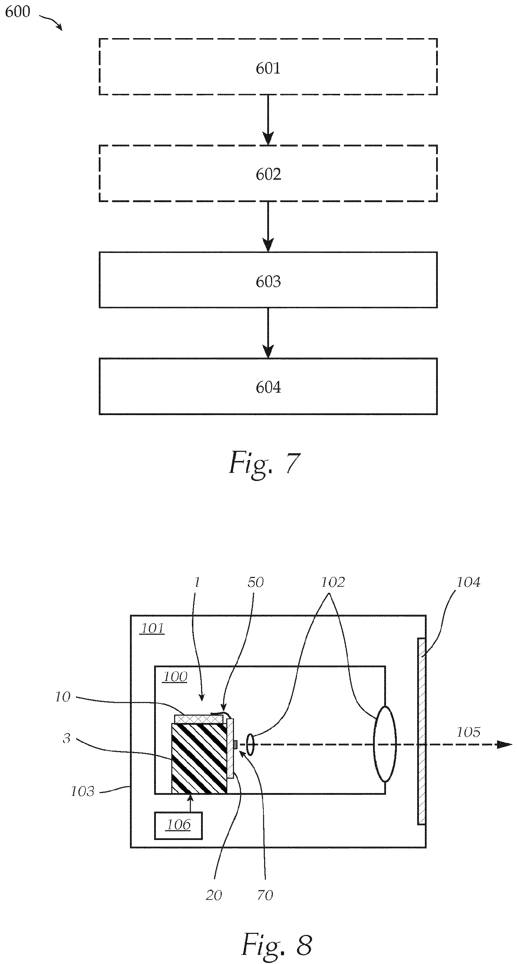

**Fig. 7** zeigt schematisch eine Ausführungsform des erfindungsgemäßen Verfahrens 600 zur Herstellung einer Leiterplattenanordnung.

Das Verfahren weist folgende Schritte auf:
- Optional: Erzeugen 601 zumindest eines durchgehenden Lochs 60-65, welches quer zu der Montageoberfläche 21 der Leiterplatte 20 verläuft, und mit zumindest einer Anschlussfläche 90, 91 auf der zweiten Leiterplatte 20 elektrisch leitend verbunden ist, wobei:
   - Das zumindest eine Loch 60-65 weist dabei eine innenliegende elektrisch leitende Oberfläche, vorzugsweise aus "electroless nickel immersion gold" (ENIG) beschichtetem Kupfer, auf.
   - Das zumindest eine Loch 60-65 weist dabei einen kleinsten Durchmesser von größer oder gleich 0,5 mm, bevorzugt größer oder gleich 1 mm, besonders bevorzugt größer oder gleich 1,5 mm, auf.
   - Die zweite Leiterplatte 20 ist zum Kontaktieren mit einem elektronischen Bauteil 80-85 vorgesehen.
- Optional: Durchtrennen 602 der Leiterplatte 20 entlang einer gedachten Trennlinie 23, wobei die Trennlinie 23 durch das zumindest eine Loch 60-65 verläuft;
   Das Durchtrennen 602 der Leiterplatte 20 erfolgt entlang einer gedachten Trennlinie 23 bevorzugt mit einer Säge.
   Durch das Durchtrennen 602 ist zumindest eine Kontaktfläche 40-45 auf der Stirnseite 22, welche quer zur Montageoberfläche 21 der Leiterplatte 20 verläuft, bereitgestellt.
- Anordnen 603 der ersten und der zweiten Leiterplatte 10, 20 auf einem gemeinsamen Halter 3, wobei:
   - Der Halter 3 ist bevorzugt ein Kühlkörper, welcher einen Winkel 2 zwischen der jeweiligen Montageoberfläche ersten und der zweiten Leiterplatte 10, 20 einstellt.
   - Der Winkel 2 liegt in einem Bereich von 80° bis 100°, bevorzugt aber bei 90°.
   - Die zweiten Kontaktflächen 40-45 liegen benachbart zu den ersten Kontaktflächen 30-35.
- Verbinden 604 der zumindest einen ersten Kontaktfläche 30-35, welche auf der Montagefläche 11 der ersten Leiterplatte 10 gelegen ist, mit der zumindest einen zweiten Kontaktfläche 40-45, welche auf der Stirnseite 22 der zweiten Leiterplatte 20 gelegen ist, mittels zumindest einem elektrisch leitenden Verbindungsmittel 50-55.

Die optionalen Schritte Erzeugen 601 und Durchtrennen 602 ermöglichen eine besonders einfache und kostengünstige Bereitstellung einer Leiterplatte 20 mit zumindest einer stirnseitigen Kontaktfläche 40-45. Diese Schritte können alternativ durch den folgenden Schritt ersetzt werden:
- Bereitstellen 605 einer Leiterplatte 20 mit zumindest einer stirnseitigen Kontaktfläche 40-45.

Somit kann die Leiterplatte 20 mit zumindest einer stirnseitigen Kontaktfläche 40-45 auch nach bekannten Verfahren hergestellt werden und die Leiterplatte 20 für die weiteren erfindungsgemäßen Verfahrensschritte 603 und 604 bereitgestellt werden. Der alternative Schritt 605 ist in den Figuren nicht dargestellt.

In diesem Zusammenhang bedeutet "benachbart gelegen", dass die ersten Kontaktflächen 30-35 in einem Randbereich der ersten Leiterplatte 10 gelegen sind, und die zweiten Kontaktflächen 40-45 an der Stirnseite 23 der zweiten Leiterplatte 20 gelegen sind, und der Randbereich der ersten Leiterplatte 10 der Stirnseite 23 der zweiten Leiterplatte 20 zugewandt angeordnet ist. In einer Ansicht der Leiterplattenanordnung 1 von oben, das heißt eine Aufsicht auf die Montageoberfläche 11 der ersten Leiterplatte 10, liegen die erste und die zweite Leiterplatte 10, 20 nebeneinander oder aneinander angrenzend.

Die Leiterplattenanordnung 1 umfasst dabei eine erste und eine zweite Leiterplatte 10, 20 mit jeweils einer Montageoberfläche 11, 21 zur Montage von elektronischen Bauteilen 70-75, 80-85.

Auf der Montageoberfläche 11 der ersten Leiterplatte 10 ist zumindest eine erste Kontaktfläche 30-35 angeordnet. Auf der Stirnseite 22, welche quer zur Montageoberfläche 21 der zweiten Leiterplatte 20 verläuft, ist zumindest eine zweite Kontaktfläche 40-45 angeordnet.

Das Verbinden 604 erfolgt optional mittels dem zumindest einen elektrisch leitenden Verbindungsmittel 50-55 durch eine Verbindungsvorrichtung 95, welche dazu vorgesehen ist, das Verbindungsmittel 50-55 auf der zumindest einen ersten Kontaktfläche 30-35 und der zumindest einen zweiten Kontaktfläche 40-45 anzubringen, wobei das Anbringen mittels einer dreiachsig parametrisierbaren Bewegung 96 der Verbindungsvorrichtung 95 ausführbar ist.

Fig. 8 zeigt ein Ausführungsbeispiel eines erfindungsgemäßen Kraftfahrzeugscheinwerfers 101, sowie ein erfindungsgemäßes Kraftfahrzeugscheinwerfer-Lichtmodul 100, umfassend eine Leiterplattenanordnung 1. Auf zumindest einer Leiterplatte 10, 20 ist zumindest eine Halbleiter-Lichtquelle, vorzugsweise eine LED, eine Hochstrom-LED oder eine Laser-Diode, angeordnet.

Der Kraftfahrzeugscheinwerfer 101 umfasst eine Optik 102, ein Scheinwerfer-Gehäuse 103 mit einem Sichtglas 104 und eine Ansteuerungselektronik 106. Der Strahlengang 105 des Lichts von der Lichtquelle ausgehend ist erkennbar.

### Bezugszeichenliste:

- 1: Leiterplattenanordnung
- 2: Winkel
- 3: Halter, Kühlkörper
- 10, 20: Leiterplatte
- 11, 21: Montageoberfläche
- 14, 24: Ebene
- 15: Schnittlinie
- 22: Stirnseite
- 23: Trennlinie
- 30-35, 40-45: Kontaktfläche
- 50-55: Verbindungsmittel, Bonddraht
- 60-65: Loch, Öffnung
- 70-75, 80-85: elektronisches Bauteil, Lichtquelle, Treiber-Elektronikschaltung
- 90, 91: Anschlussfläche
- 92, 93: Leiterbahn
- 95: Bond-Vorrichtung
- 96: Bewegung der Bond-Vorrichtung
- 100: Lichtmodul
- 101: Kraftfahrzeugscheinwerfer
- 102: Optik
- 103: Gehäuse
- 104: Sichtglas
- 105: Strahlengang des Lichts von der Lichtquelle
- 106: Ansteuerungselektronik
- 500, 600: Verfahren
- 501, 502, 601-605: Verfahrensschritte

## Patentansprüche

1. Leiterplattenanordnung (1), umfassend eine erste und eine zweite Leiterplatte (10, 20) mit jeweils einer Montageoberfläche (11, 21) zur Montage von elektronischen Bauteilen (70-75, 80-85), **dadurch gekennzeichnet, dass** die erste und die zweite Leiterplatte (10, 20) zueinander in einem Winkel (2) in einem Bereich von 80° bis 100°, bevorzugt unter einem Winkel von 90°, angeordnet sind,
und zumindest eine erste Kontaktfläche (30-35) auf einer Montageoberfläche (11) der ersten Leiterplatte (10) angeordnet ist,
und zumindest eine zweite Kontaktfläche (40-45) der zweiten Leiterplatte (20) auf einer Stirnseite (22), welche quer zu einer Montageoberfläche (21) der zweiten Leiterplatte (20) verläuft, angeordnet ist,
und zumindest ein elektrisch leitendes Verbindungsmittel (50-55) von der zumindest einen ersten Kontaktfläche (30-35) zur zumindest einen zweiten Kontaktfläche (40-45) verläuft.

2. Leiterplattenanordnung (1) nach Anspruch 1, **dadurch gekennzeichnet, dass** sich die Ebenen (14, 24), in denen die Montageoberflächen (11, 21) der ersten und zweiten Leiterplatten (10, 20) gelegen sind, außerhalb der Montageoberfläche (11) der ersten Leiterplatte (10) schneiden.

3. Leiterplattenanordnung (1) nach Anspruch 1 oder 2, **dadurch gekennzeichnet, dass** die erste und die zweite Leiterplatte (10, 20) auf einem gemeinsamen Halter (3) angeordnet sind, welcher bevorzugt ein Kühlkörper ist.

4. Leiterplattenanordnung (1) nach einem der vorhergehenden Ansprüche, **dadurch gekennzeichnet, dass** das elektrisch leitende zumindest eine Verbindungsmittel (50-55) ein Bonddraht ist, vorzugsweise mit einem Durchmesser in einem Bereich von 100 µm bis 1000 µm, besonders bevorzugt in einem Bereich von 400 µm bis 600µm, und der Bonddraht vorzugsweise Aluminium beinhaltet, und das zumindest eine Verbindungsmittel (50-55) von der ersten Kontaktfläche (30-35) zur zweiten Kontaktfläche (40-45) durch ein Bond-Verfahren, vorzugsweise ein Wedge-Bond-Verfahren, hergestellt ist.

5. Kraftfahrzeugscheinwerfer-Lichtmodul (100), **umfassend** eine Leiterplattenanordnung (1) nach einem der vorhergehenden Ansprüche, wobei auf zumindest einer Leiterplatte (10, 20) zumindest eine Halbleiter-Lichtquelle, vorzugsweise eine LED, eine Hochstrom-LED oder eine Laser-Diode, angeordnet ist.

6. Kraftfahrzeugscheinwerfer (101), umfassend ein Kraftfahrzeugscheinwerfer-Lichtmodul (100) nach dem vorhergehenden Anspruch.

7. Verfahren (500) zur Herstellung einer Leiterplatte (20) mit zumindest einer stirnseitigen Kontaktfläche (40-45) für eine Leiterplattenanordnung (1) nach einem der Ansprüche 1 bis 4, **dadurch gekennzeichnet, dass** folgende Verfahrensschritte ausgeführt werden:
- Erzeugen (501) zumindest eines durchgehenden Lochs (60-65), welches quer zu der Montageoberfläche (21) der Leiterplatte (20) verläuft, wobei das zumindest eine Loch (60-65) eine innenliegende elektrisch leitende Oberfläche, vorzugsweise aus "electroless nickel immersion gold" (ENIG) beschichtetem Kupfer, aufweist, und mit zumindest einer Anschlussfläche (90, 91) auf der Leiterplatte (20), welche zum Kontaktieren mit einem elektronischen Bauteil (80-85) vorgesehen ist, elektrisch leitend verbunden ist;
- Durchtrennen (502) der Leiterplatte (20) entlang einer gedachten Trennlinie (23), bevorzugt mit einer Säge, wobei die Trennlinie (23) durch das zumindest eine Loch (60-65) verläuft, wodurch zumindest eine Kontaktfläche (40-45) auf der Stirnseite (22), welche quer zur Montageoberfläche (21) der Leiterplatte (20) verläuft, bereitgestellt ist.

8. Verfahren (500) zur Herstellung einer Leiterplatte (20) mit zumindest einer stirnseitigen Kontaktfläche (40-45) nach dem vorhergehenden Anspruch, **dadurch gekennzeichnet, dass** das zumindest eine Loch (60-65) einen kleinsten Durchmesser von größer oder gleich 0,5 mm, bevorzugt größer oder gleich 1 mm, besonders bevorzugt größer oder gleich 1,5 mm, aufweist.

9. Verfahren (600) zur Herstellung einer Leiterplattenanordnung nach einem der Ansprüche 1 bis 4, **dadurch gekennzeichnet, dass** die Leiterplattenanordnung (1) eine erste und eine zweite Leiterplatte (10, 20) mit jeweils einer Montageoberfläche (11, 21) zur Montage von elektronischen Bauteilen (70-75, 80-85) umfasst, wobei zumindest eine erste Kontaktfläche (30-35) auf der Montageoberfläche (11) der ersten Leiterplatte (10) angeordnet ist, und zumindest eine zweite Kontaktfläche (40-45) auf der Stirnseite (22), welche quer zur Montageoberfläche (21) der zweiten Leiterplatte (20) verläuft, angeordnet ist, und folgende Verfahrensschritte ausgeführt werden:
- Anordnen (603) der ersten und der zweiten Leiterplatte (10, 20) auf einem gemeinsamen Halter (3), welcher bevorzugt ein Kühlkörper ist, und in einem Winkel (2) in einem Bereich von 80° bis 100°, bevorzugt in einem Winkel (2) von 90°, zueinander, wobei die zumindest eine zweite Kontaktfläche (40-45) benachbart zur zumindest einen ersten Kontaktfläche (30-35) gelegen ist;
- Verbinden (604) der zumindest einen ersten Kontaktfläche (30-35), welche auf der Montagefläche (11) der ersten Leiterplatte (10) gelegen ist, mit der zumindest einen zweiten Kontaktfläche (40-45), welche auf der Stirnseite (22) der zweiten Leiterplatte (20) gelegen ist, mittels zumindest einem elektrisch leitenden Verbindungsmittel (50-55).

10. Verfahren (600) zur Herstellung einer Leiterplattenanordnung nach dem vorhergehenden Anspruch, **dadurch gekennzeichnet, dass** das Verbinden (604) mittels dem zumindest einem elektrisch leitenden Verbindungsmittel (50-55) durch eine Verbindungsvorrichtung (95) erfolgt, welche dazu vorgesehen ist, das Verbindungsmittel (50-55) auf der zumindest einen ersten Kontaktfläche (30-35) und der zumindest einen zweiten Kontaktfläche (40-45) anzubringen, wobei das Anbringen mittels einer dreiachsig parametrisierbaren Bewegung (96) der Verbindungsvorrichtung (95) ausführbar ist.

11. Verfahren (600) zur Herstellung einer Leiterplattenanordnung nach einem der Ansprüche 9 oder 10, **dadurch gekennzeichnet, dass** vor dem Schritt des Anordnens (603) folgende Verfahrensschritte ausgeführt werden:
- Erzeugen (601) zumindest eines durchgehenden Lochs (60-65), welches quer zu der Montageoberfläche (21) der Leiterplatte (20) verläuft, wobei das zumindest eine Loch (60-65) eine innenliegende elektrisch leitende Oberfläche, vorzugsweise aus "electroless nickel immersion gold" (ENIG) beschichtetem Kupfer, aufweist, und mit zumindest einer Anschlussfläche (90, 91) auf der Leiterplatte (20), welche zum Kontaktieren mit einem elektronischen Bauteil (80-85) vorgesehen ist, elektrisch leitend verbunden ist;
- Durchtrennen (602) der Leiterplatte (20) entlang einer gedachten Trennlinie (23), bevorzugt mit einer Säge, wobei die Trennlinie (23) durch das zumindest eine Loch (60-65) verläuft, wodurch zumindest eine Kontaktfläche (40-45) auf der Stirnseite (22), welche quer zur Montageoberfläche (21) der Leiterplatte (20) verläuft, bereitgestellt ist.

12. Verfahren (600) zur Herstellung einer Leiterplattenanordnung nach dem vorhergehenden Anspruch, **dadurch gekennzeichnet, dass** das zumindest eine Loch (60-65) einen kleinsten Durchmesser von größer oder gleich 0,5 mm, bevorzugt größer oder gleich 1 mm, besonders bevorzugt größer oder gleich 1,5 mm, aufweist.
